# EUROPEAN PATENT APPLICATION

(11) **EP 4 733 141 A1**
(43) Date of publication of application: **29.04.2026**
(21) Application number: 24208108.1
(22) Date of filing: 22.10.2024
(51) Int. Cl.: B60R 16/023, B60L 53/22, B60L 53/66

(54) **AN ELECTRICAL COMPONENT BOX FOR A HEAVY- DUTY VEHICLE AND A HEAVY-DUTY VEHICLE COMPRISING SUCH AN ELECTRICAL COMPONENT BOX**

(71) Applicant: Volvo Truck Corporation, 405 08 Göteborg (SE)
(72) Inventor: HIRKO, Anthony, Stokesdale, 27357 (US); PEDRO, Alfredo, McLeansville, 27301 (US); BIRATH, Albin, Rural Hall, 27045 (US); GAUMER, Christopher, Lehighton, 18235 (US); JENNINGS, Joshua, High Point, 27262 (US)
(74) Representative: Zacco Sweden AB

(57) **Abstract**

An electrical component box for a heavy-duty vehicle, comprising a bottom floor, a first panel and a second panel, which together, at least partly, define an internal space configured to house electrical components. The electrical component box also comprises a pivotable panel configured to support a plurality of electrical components. The pivotable panel has a closed position and an open position, A locking mechanism is configured to lock the pivotable panel in said closed position by securing the pivotable panel to the first panel and the second panel, thereby causing the pivotable panel to contribute in absorbing load exerted on at least one of the first and second panel, and preventing the pivotable panel from pivoting. Unlocking the pivotable panel, by the locking mechanism, allows the pivotable panel to be pivoted from the closed position to the open position.

## Description

### TECHNICAL FIELD

The disclosure relates generally to an electrical component box. In particular aspects, the disclosure relates to an electrical component box for a heavy-duty vehicle and to a heavy-duty vehicle comprising such an electrical component box. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Electrical power boxes on heavy-duty vehicles may contain batteries and related electrical power equipment. As technology evolves, more and more electrical complexity is introduced, resulting in challenges as regards manufacturability and serviceability inside the electrical power box.

### SUMMARY

According to a first aspect of the disclosure, there is provided an electrical component box for a heavy-duty vehicle, comprising:
- a bottom floor,
- a first panel extending substantially perpendicularly upwards in relation to the bottom floor,
- a second panel extending substantially perpendicularly upwards in relation to the bottom floor and extending substantially in parallel with the first panel,
   wherein the bottom floor, the first panel and the second panel together, at least partly, define an internal space configured to house electrical components,
- a pivotable panel configured to support a plurality of electrical components, such as fuses, the pivotable panel having:
   i) a closed position, in which access to the supported electrical components and at least some other electrical components housed in said internal space is counteracted, and
   ii) an open position, in which access to the supported electrical components and said at least some other electrical components housed in said internal space is enabled,
      - a locking mechanism configured to lock the pivotable panel in said closed position by securing the pivotable panel to the first panel and the second panel, thereby causing the pivotable panel to contribute in absorbing load exerted on at least one of the first and second panel, and preventing the pivotable panel from pivoting,
         wherein unlocking of the pivotable panel, by the locking mechanism, allows the pivotable panel to be pivoted from the closed position to the open position.
         The first aspect of the disclosure may seek to facilitate for operators to gain initial assembly access to electrical connections behind the pivotable panel, while also allowing aftermarket technicians access to the interior components without disconnecting any electrical harnesses. A technical benefit may include that ease of access is achieved without making any substantial compromise with respect to structural rigidity of the electrical component box. Thus, by providing a pivotable panel which contributes in absorbing load exerted on the first and/or second panel, good structural integrity of the entire electrical component box may be achieved, while also providing the benefit of ease of accessibility. A further advantage is that the entire electrical component box may suitably be assembled off the main production line of the heavy-duty vehicle in which it is to be installed.

The electrical component box may include any electrical components which may be useful for a heavy-duty vehicle. Thus, the electrical component box may, for example, be in the form of an electrical power box, battery box, fuse box, etc., and may include various different electrical components which are interconnected with each other or separately arranged from each other within the electrical component box.

As indicated above, the pivotable panel is configured to support electrical components. Having electrical components supported directly on the pivotable panel may be advantageous as this also contributes to the general desire to provide easy accessibility. In examples in which the electrical components is or includes fuses, the pivotable panel may also be referred to as a fuse panel.

Thus, from the above, it should be understood that the electrical component box of this disclosure can provide dual ease of accessibility. On the one hand it may allow easy access to electrical components supported by the pivotable panel. On the other hand, it may also allow easy access to electrical components which are not directly supported by pivotable panel, and which are concealed behind the pivotable panel when it is closed. By pivoting the pivotable panel into the open position, access can be gained to the previously concealed electrical components.

Optionally in some examples, including in at least one preferred example, the electrical component box may further comprise:
- a pivoting mechanism for enabling pivoting of the pivotable panel between the closed position and open position, wherein the pivoting mechanism comprises a first pivot and a second pivot, wherein the pivotable panel comprises a first pivoting flange forming part of the pivoting mechanism and being provided with an open slot configured to receive said first pivot, and a second pivoting flange provided with a through hole configured to receive and enclose said second pivot.
   A technical benefit may include that this allows for simple attachment of the pivotable panel during assembling of the electrical component box. Suitably, the second pivot may first be inserted into the through hole of the second pivoting flange, and then the first pivoting flange may be approached towards the first pivot so that the first pivot enters and is inserted into the open slot of the first pivoting flange. The pivots may be of any suitable type, such as pivots including a pin portion with or without a limiting end flange portion, etc.

Optionally in some examples, including in at least one preferred example, the first pivot may be connected to or forms part of the first panel, and the second pivot is connected to or forms part of the second panel.
A technical benefit may include that from a practical perspective the first and second panels present good fixation areas for placement of such first and second pivots, respectively. Since the first and second panels may present large available areas, and since you would normally desire to have as good accessibility as possible with respect to the electrical components when the pivotable panel is in its open position, the area of placement of the first and second pivots may be adequately selected to achieve such goal.

Optionally in some examples, including in at least one preferred example, the bottom floor may be substantially planar and extend in a geometrical plane, wherein in the closed position of the pivotable panel an open end of the open slot is facing said geometrical plane.
A technical benefit may include that this will assist in keeping the open slot in place on the first pivot. Put differently, in the closed position of the pivotable panel, the pivotable panel may be held in a relatively stable manner even without the locking mechanism. This facilitates manufacturing and service. It can thus be understood that the open end of the open slot may be directed towards the ground on which the heavy-duty vehicle stands. Hereby, the effect of gravity may be used to keep the pivotable panel in the closed position, i.e. the first pivoting flange of the pivotable panel may "hang" on the first pivot due to gravity.

Optionally in some examples, including in at least one preferred example, the locking mechanism may comprises at least one first fastener and at least one second fastener, wherein the pivotable panel has a first securing portion at one end of the pivotable panel, the first securing portion being configured to receive said at least one first fastener in a first direction, wherein the pivotable panel has a second securing portion at an opposite end of the pivotable panel, the second securing portion being configured to receive said at least one second fastener in a second direction which is perpendicular to said first direction.
A technical benefit may include that by having differently oriented fasteners and differently oriented securing portions, the structural rigidity and the ability to absorb load may be further improved. The fasteners may, at least in some examples, suitably include bolts and associated components such as nuts, etc. Thus, the fasteners and the associated securing portion may suitably form bolted joints.

Optionally in some examples, including in at least one preferred example, the pivotable panel may have a supporting surface for supporting at least some of said plurality of electrical components, the supporting surface extending from said one end to said opposite end of the pivotable panel, wherein the first securing portion is formed by a securing flange which is projecting substantially perpendicularly to the supporting surface of the pivotable panel and substantially in parallel with the first panel, wherein the securing flange is provided with at least one opening for receiving said at least one first fastener.
A technical benefit may include that this allows for a structurally strong connection to be provided, and in particular allowing the first fastener to tightly interconnect the substantially parallelly aligned securing flange and first panel.

Optionally in some examples, including in at least one preferred example, the second securing portion may be formed by an area of the pivotable panel which is parallel with said supporting surface, wherein the second securing portion is provided with at least one opening for receiving said at least one second fastener.
A technical benefit may include that providing such a second securing portion is technically convenient as it may, for instance, be made in one piece with the supporting surface. For example, there is no bending or welding action needed to provide the second securing portion at said opposite end of the pivotable panel.

Optionally in some examples, including in at least one preferred example, the first panel may have an inwardly facing side which faces said internal space and an opposite outwardly facing side, wherein said at least one first fastener is configured to extend from the outwardly facing side through the first panel to the inwardly facing side and into the first securing portion of the pivotable panel.
A technical benefit may include that this allows a secure and tight connection to be provided between the first panel and the first securing portion of the pivotable panel, contributing to the overall structural integrity of the electrical component box. Suitably, the first fastener may be in the form of, or include, a bolt having a head from which a shaft extends. In such case, the bolt may suitably be inserted from the outwardly facing side of the first panel such that, when the bolt has been tightened, the head abuts/presses against the outwardly facing side of the first panel and the shaft extends through the first panel and into the first securing portion of the pivotable panel.

Optionally in some examples, including in at least one preferred example, the second panel may have an inwardly facing side which faces said internal space and an opposite outwardly facing side, wherein the second panel may have a fastener-receiving flange projecting at an angle, such as perpendicularly, to said inwardly and outwardly facing sides of the second panel, wherein said at least one second fastener may be configured to extend from the second securing portion of the pivotable panel and into the fastener-receiving flange of the second panel.
A technical benefit may include that, analogously to the previous discussions, this allows a secure and tight connection to be provided between the second securing portion of the pivotable panel and the second panel, contributing to the overall structural integrity of the electrical component box. Suitably, the second fastener may be in the form of, or include, a bolt having a head from which a shaft extends. In such case, the bolt may suitably be arranged such that, when the bolt has been tightened, the head abuts/presses against the second securing portion of the pivotable panel and the shaft extends through the second securing portion of the pivotable panel and into the second panel.

Optionally in some examples, including in at least one preferred example, the pivotable panel may be provided with an elongated reinforcement beam, such as a beam having a U-shaped cross-section, wherein the direction of extension of the elongated reinforcement beam may be parallel with a direction from the first panel to the second panel. A technical benefit may include that the elongated reinforcement beam may contribute in absorbing load exerted on at least one of the first and second panel. It may furthermore increase the structural rigidity of the pivotable panel as such. From the above, it can also be understood that, in at least some examples, the elongated reinforcement beam may suitably extend in a direction from one end of the pivotable panel to said opposite end of the pivotable panel.

Optionally in some examples, including in at least one preferred example, the pivotable panel may have an inboard side and an opposite outboard side, wherein in the closed position of the pivotable panel the inboard side may be concealed and in the open position of the pivotable panel the inboard side may be exposed, wherein the pivotable panel may be provided with a window, wherein said plurality of electrical components supported by the pivotable panel may be supported on the outboard side and project through the window to the inboard side.
A technical benefit may include that a space-efficient arrangement may be provided. As can be readily understood, it may be desirable to conceal sensitive parts of electrical components during normal use of the heavy-duty vehicle. Therefore, for most of the time, during normal use of the heavy-duty vehicle, the pivotable panel is intended to be in its closed position. It therefore makes sense to provide the sensitive parts on the inboard side of the pivotable panel as these will be concealed in said closed position. However, depending on the dimension of any particular electrical component, the overall volume of such an electrical component may be rather bulky and may risk taking up too much of the internal space intended to also house other electrical components. Therefore, by allowing a part of the electrical component to be on the outboard side but allowing sensitive parts to be on the inboard side thanks to the window, the volume taken up on the inboard side and in the internal space, can be reduced. The window may, for example, be in the form of one or more apertures through the pivotable panel, or one or more cutouts in the pivotable panel, allowing electrical components to extend from said outboard side, through such aperture(s) or cutout(s), and to the inboard side.

Optionally in some examples, including in at least one preferred example, the second panel may comprise an abutment surface against which the pivotable panel lands upon its pivoting motion from the closed position to the open position, wherein in said open position the pivotable panel may be in contact with said abutment surface.
A technical benefit may include that a well-defined open position may be achieved. Hereby, the risk of a person pivoting the pivotable panel too much, possibly causing parts of the electrical component box to become damaged, may be reduced.

Optionally in some examples, including in at least one preferred example, the electrical component box may be a battery box, wherein said internal space is configured to receive one or more batteries between the bottom floor and the pivotable panel.
A technical benefit may include that a battery box may include numerous different electrical components which have traditionally been hard to access during e.g. service. By implementing the teachings of this disclosure for a battery box, the numerous different electrical components may be made more easily accessible. Furthermore, the battery box may suitably be assembled off the main production line of the heavy-duty vehicle in which it is to be installed. For example, electrical connections behind the pivotable panel may be easily accessible for initial factory assembly operators as the pivotable panel can easily be pivoted to its open position. Also, aftermarket technicians may be allowed easy access to the interior electrical components of the battery box without needing to disconnect any electrical harness.

Optionally in some examples, including in at least one preferred example, the electrical component box may further comprise:
- a tray defining said bottom floor of the battery box, wherein said first and second panels are fixated to said tray, wherein said one or more batteries are configured to be received on said tray or on a drawer received by the tray.
   A technical benefit may include that fixating the first and second panels to the tray may further improve the structural rigidity of the electrical component box. Furthermore, the tray provides a convenient location for placing said one or more batteries.

Optionally in some examples, including in at least one preferred example, the electrical component box may further comprise:
- a third panel extending substantially perpendicularly upwards in relation to the bottom floor, and extending substantially in parallel with the first panel and the second panel, wherein the second panel is located between the first panel and the third panel.
   A technical benefit may include that an additional space may be provided for additional components (electrical and/or non-electrical components), which do not necessarily need to be concealed by the pivotable panel. For instance, the third panel may be provided with mounting brackets and isolators, such as to hold high voltage cables, coolant hoses, etc.

Optionally in some examples, including in at least one preferred example, the locking mechanism may comprise at least two first fasteners. A technical benefit may include that a more robust connection between the first panel and the pivotable panel may be obtained, reducing the risk of undesired rotation of the pivotable panel when being locked in said closed position.

Optionally in some examples, including in at least one preferred example, the locking mechanism may comprise at least two fasteners. A technical benefit may include that a more robust connection between the second panel and the pivotable panel may be obtained, reducing the risk of undesired rotation of the pivotable panel when being locked in said closed position.

According to a second aspect of the disclosure, there is provided a heavy-duty vehicle comprising an electrical component box according to the first aspect, including any example thereof. The second aspect of the disclosure may seek to address the corresponding matters as discussed in relation to the first aspect. Technical benefits of the second aspect may be largely analogous to technical benefits of the first aspect, including any examples thereof.

Optionally in some examples, including in at least one preferred example, the electrical component box may be installed on a lateral side of a heavy-duty vehicle and may be accessible from outside of the heavy-duty vehicle.
A technical benefit may include that the electrical component box may, during manufacturing, simply be assembled separately from the main assembly line, and then conveniently mounted to the lateral side of the heavy-duty vehicle. This also allows for easy access if service of the electrical component box would later be desired.

In examples in which the electrical component box is provided with cables in said internal space, and which cable are connected to the electrical components supported by the pivotable panel, then such cables may suitably be installed with sufficient slack to allow for the pivoting motion of the pivotable panel.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

### BRIEF DESCRIPTION OF THE DRAWINGS

Examples are described in more detail below with reference to the appended drawings.
**FIG. 1** schematically illustrates a heavy-duty vehicle according to one example of this disclosure.
**FIGS. 2-3** illustrate different perspective views of an electrical component box in accordance with at least one example of this disclosure, wherein a pivotable panel is in a closed position.
**FIGS. 4-5** illustrate corresponding perspective views of the electrical component box of **FIGS. 2-3****,** wherein the pivotable panel is in an open position.
**FIG. 6** is an isolated view of the pivotable panel.
**FIG. 7a** schematically illustrates an electrical component box according to at least one example, wherein a pivotable panel is in a closed position.
**FIG. 7b** schematically illustrates the electrical component box, wherein the pivotable panel is in an open position.

### DETAILED DESCRIPTION

The detailed description set forth below provides information and examples of the disclosed technology with sufficient detail to enable those skilled in the art to practice the disclosure.

Heavy-duty vehicles of today include many different electrical components. Some of those components can be provided in an electrical component box. It is envisaged that in the future, more and more electrical complexity will be introduced. This will lead to increased challenges as regards manufacturability and serviceability inside such an electrical component box. In accordance with the teachings of the present disclosure, the electrical component box may be provided with a pivotable panel which in an open position can provide access to electrical components which are otherwise concealed in the electrical component box. The pivotable panel also simplifies assembling/mounting of the electrical components inside the electrical component box. By incorporating the pivotable panel in such a way that, in its closed position, it contributes to the structural rigidity/strength of the electrical component box, not only can the accessibility be improved, but it can be improved without compromising the overall structural integrity.

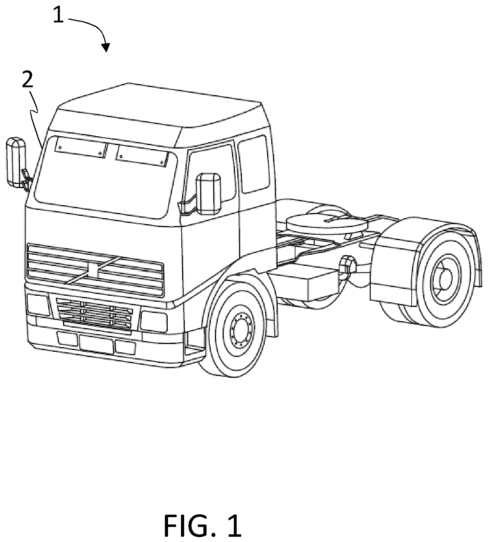

**FIG. 1** schematically illustrates a heavy-duty vehicle **1** according to one example of this disclosure. The exemplary illustration in **FIG. 1** shows a tractor unit for towing a trailer unit (not shown), which together make up a semitrailer vehicle. However, the teachings of this disclosure are applicable to other types of heavy-duty vehicles as well. For instance, the heavy-duty vehicle may be a different type of heavy-duty vehicle for cargo transport, such as a truck, or a truck with a dolly unit arranged to tow a trailer unit, etc. Other conceivable examples include a bus, construction equipment, etc. The heavy-duty vehicle 1 may, for instance, be an electric vehicle or a hybrid electric vehicle. The illustrated heavy-duty vehicle **1** comprises a cabin **2** in which a driver may operate the heavy-duty vehicle **1.** However, in other exemplary embodiments the heavy-duty vehicle **1** may be an autonomous, i.e., self-driving, heavy-duty vehicle.

The heavy-duty vehicle **1** may comprise an electrical component box as disclosed herein (including any example thereof).

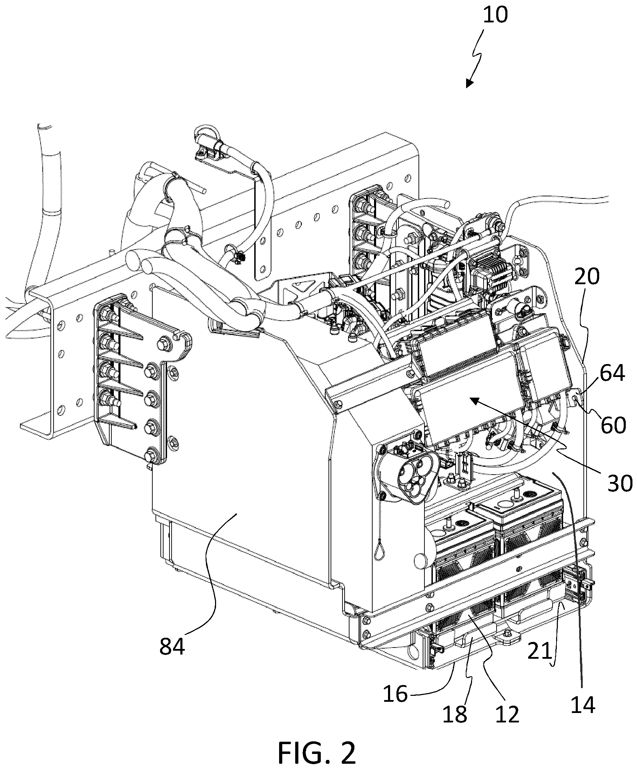

**FIGS. 2-3** illustrate different perspective views of an electrical component box **10** in accordance with at least one example of this disclosure. The electrical component box **10** may, for instance, be mounted on a heavy-duty vehicle such as the heavy-duty vehicle **1** shown in **FIG. 1** or in any other heavy-duty vehicle as previously discussed herein. The electrical component box **10** may be configured to house and/or receive various electrical components. For instance, it may be configured to receive one or more batteries **12.** In such cases, the electrical component box **10** may also be referred to as a battery box. In the illustrated example two batteries **12** have been illustrated as having been received in an internal space **14** of the electrical component box **10.** As illustrated in **FIGS. 2-3** the electrical component box **10** (in this example, a battery box) may further comprise a tray **16.** The batteries **12** may thus be configured to be received on the tray **16** (or on a drawer **18** received by such a tray **16).**

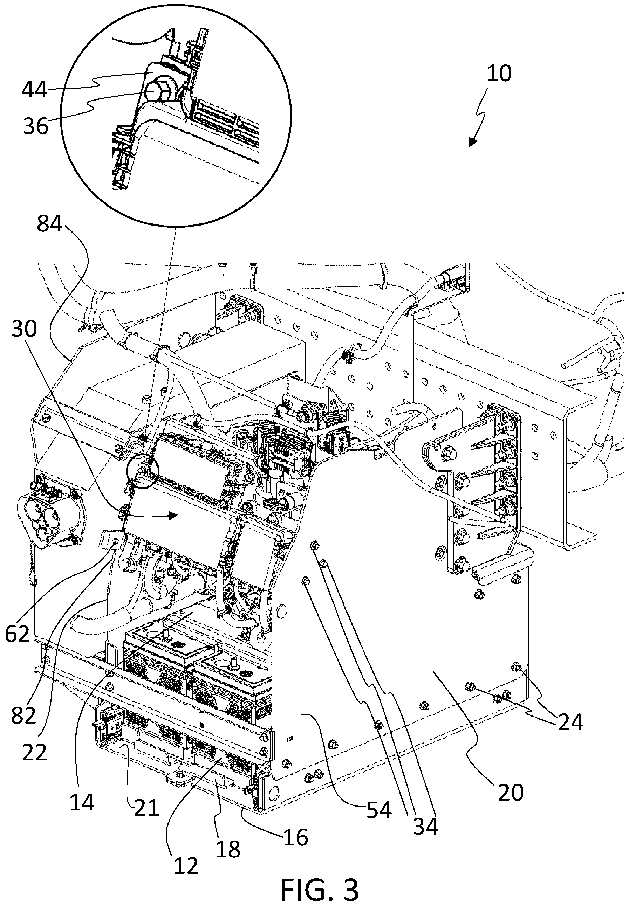

As can also be seen in **FIGS. 2-3****,** the internal space **14** can be configured to house numerous other electrical components. The internal space **14** may, at least partly, be defined by a first panel **20,** a second panel **22** and a bottom floor **21** (the second panel **22** being visible in **FIG. 3****).** In the illustrated example, said tray **16** may define the bottom floor **21** (i.e. an upwardly facing side of the tray **16),** whereas in other examples the bottom floor **21** may be provided by other structure or structures. The first panel **20** extends substantially perpendicularly upwards in relation to the bottom floor **21.** The second panel **22** also extends substantially perpendicularly upwards in relation to the bottom floor **21.** Furthermore, the second panel **22** extends substantially in parallel with the first panel **20.** The first panel **20** is thus spaced apart from the second panel **22** and may thus together form some of the boundaries of the internal space **14.** The first panel **20** and the second panel **22** may suitably be fixated to the tray **16.** The tray may suitably have raised edges to which the first and second panels **20, 22,** respectively, may be fixated. In **FIG. 3****,** for example, it is illustrated how the first panel **20** is fixated to such a raised edge of the tray **16** by means of a plurality of bolts **24** arranged in a row. The second panel **22** may be fixated in corresponding manner to another raised edge of the tray **16** on the opposite side of the tray **16.**

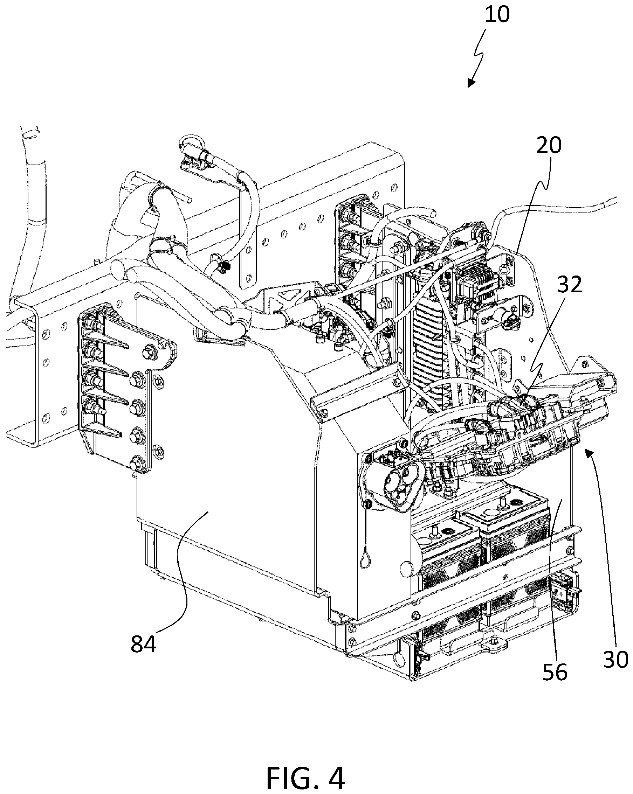

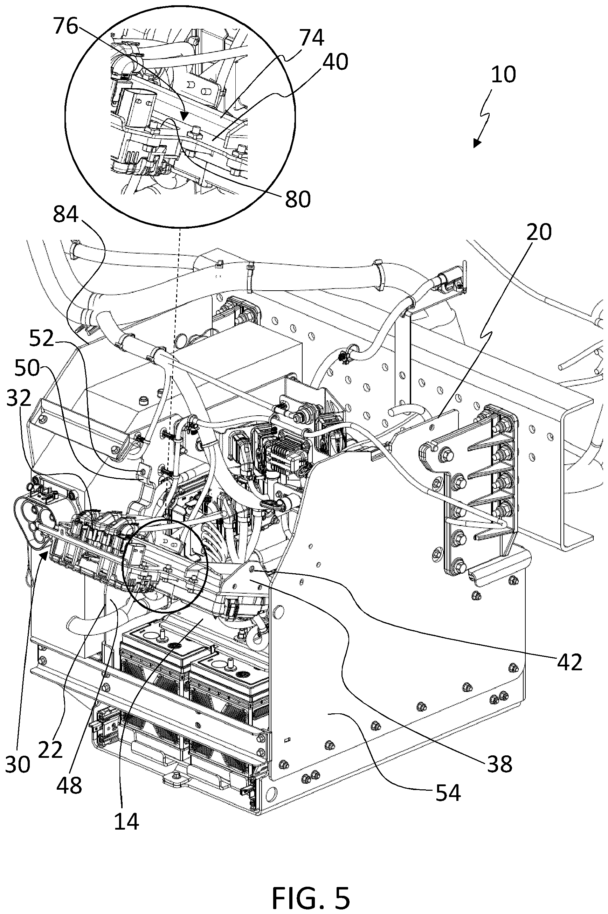

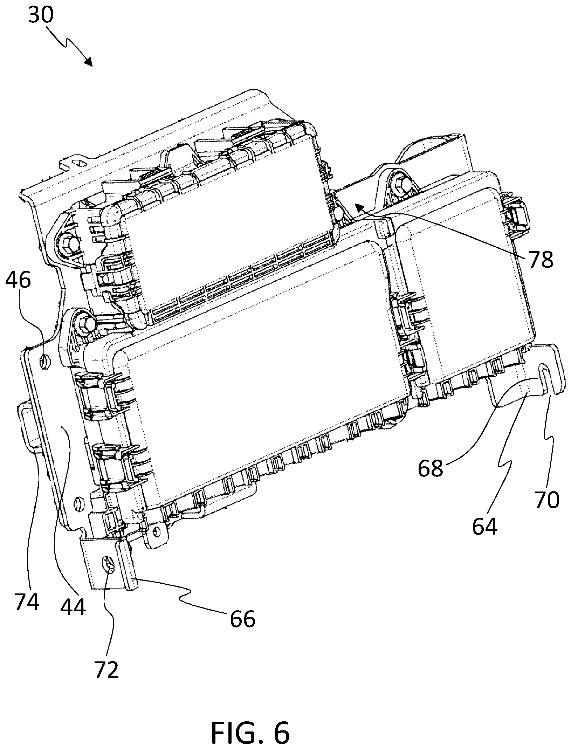

The electrical component box **10** further comprises a pivotable panel **30.** In **FIGS. 2** and **3****,** the pivotable panel **30** is shown in a closed position. In **FIGS. 4** and **5** the pivotable panel **30** is shown in an open position. Furthermore, in **FIG. 6****,** the pivotable panel **30** is shown in isolation, to provide a more clear view thereof. As indicated in **FIGS. 4** and **5****,** the pivotable panel **30** is configured to support a plurality of electrical components **32.** For example, the supported electrical components **32** may be/include fuses. Thus, in some examples, fuses may suitably be supported by the pivotable panel **30.** In such cases, the pivotable panel **30** may also be referred to as a fuse panel. The pivotable panel **30** may extend between the first panel **20** and the second panel **22,** however, the extension of the pivotable panel **30** does not necessarily have to correspond to the separating distance between the first panel **20** and the second panel **22.** It may, for example, be shorter.

In the closed position **(****FIGS. 2** and **3****)** of the pivotable panel **30,** access is counteracted with respect to those electrical components **32** (visible in **FIGS. 4** and **5****)** that are supported by the pivotable panel **30.** Access is also counteracted with respect to at least some other electrical components that are housed inside the internal space **14,** in particular if the electrical component box **10** is mounted as intended on a heavy-duty vehicle.

In the open position **(****FIGS. 4** and **5****)** of the pivotable panel **30,** access to the supported electrical components **32** is enabled. Access is also enabled to said other electrical components housed in the internal space **14.**

The electrical component box **10** further comprises a locking mechanism **34, 36.** With reference to **FIG. 3****,** in this illustrative example, the locking mechanism is illustrated as comprising a first set of fasteners **34,** in the following referred to as first fasteners **34.** More specifically, the first fasteners **34** are illustrated in the form of three bolts. A different number of first fasteners **34** (such as bolts) is, of course, also conceivable, such as one, two, four or more. **FIG. 3** also illustrates, in the enlarged detail of **FIG. 3****,** that the locking mechanism **34, 36** may comprise a second set of fasteners **36** (see enlarged detail in **FIG. 3****),** in the following referred to as second fasteners **36.** The second fasteners **36** may for example include two or more bolts, although only one is visible in **FIG. 3****.** However, a different number of second fasteners **36** (such as bolts) is, of course, also conceivable, such as one, three or more. The general purpose of the locking mechanism **34, 36** will be discussed below, and it will be readily understood that the exemplary illustration of bolts is just one conceivable example. The locking mechanisms **34, 36** may thus be designed and/or configured in any suitable way as long as it achieves the below discussed general purpose.

The general purpose of the locking mechanism **34, 36** is that it should be configured to lock the pivotable panel **30** in the closed position by securing the pivotable panel **30** to the first panel **20** and to the second panel **22,** so as to cause the pivotable panel **30** to contribute in absorbing load exerted on at least one of the first panel **20** and the second panel **22,** and so as to prevent the pivotable panel **30** from pivoting. Unlocking the pivotable panel **30,** by the locking mechanism **34, 36** should allow the pivotable panel **30** to be pivoted from the closed position to the open position. In the illustrated open position of **FIGS. 4** and **5****,** the fasteners **34, 36** have been removed and thereby the pivotable panel **30** has been allowed to pivot to the open position.

From the illustrated example in **FIG. 3****,** it can be understood that in a general sense the locking mechanism **34, 36** may comprise at least one first fastener **34,** such as the three first fasteners **34** shown in **FIG. 3****.** Similarly, it can be understood that the locking mechanism **34, 36** may comprise at least one second fastener **36.** To achieve a locking of the pivotable panel **30** in the closed position, it may suitably be provided with securing portions with which the fasteners **34, 36** can become engaged. For instance, as best seen in **FIG. 5****,** the pivotable panel **30** may have a first securing portion **38** at one end of the pivotable panel **30.** In this example, the first securing portion **38** is illustrated as being formed by a securing flange **38** which projects substantially perpendicularly to a supporting surface **40** (see enlarged detail of **FIG. 5****)** of the pivotable panel **30,** which supporting surface **40** carries said supported electrical components **32.** The securing flange **38** furthermore extends substantially in parallel with the first panel **20.** As can be seen in **FIG. 5****,** the securing flange **38** may be provided with at least one opening **42** for receiving said at least one first fastener **34.** In this example, since there are three fasteners **34** provided, the number of openings **42** is three, i.e. the number of openings **42** may suitably correspond to the number of first fasteners **34.**

Similarly, as seen in the enlarged detail of **FIG. 3****,** the pivotable panel **32** may suitably have a second securing portion **44,** which may be located at an opposite end of the pivotable panel **30** as compared to the first securing portion **38.** The second securing portion **44** may thus be configured to receive said at least one second fastener **36.** As can be understood from this example, the first securing portion **38** may be configured to receive the first fasteners **34** in a first direction (in this example the first direction is perpendicular to the main planes of the first and second panels **20, 22),** and the second securing portion **44** may be configured to receive the second fasteners **36** in a second direction which is perpendicular to the first direction. This provides good structural integrity to the electrical component box **10** when the pivotable panel **30** is locked in the closed position **(****FIGS. 2** and **3****).**

From the above it can be understood that, as regards the supporting surface **40** of the pivotable panel **30** (see enlarged detail of **FIG. 5****),** it may suitably extend from one end of the pivotable panel **30,** where the first securing portion **38** is located, to the opposite other end, where the second securing portion **44** (see enlarged detail of **FIG. 3****)** is located.

The second securing portion **44** may suitably be formed by an area of the pivotable panel **30** which is parallel to the supporting surface **40.** As can be seen in **FIG. 6****,** the second securing portion **44** may be provided with at least one opening **46** for receiving the at least one second fastener **36.** In particular, **FIG. 6** shows that two such openings **46** may be provided in the second securing portion **44** of the pivotable panel **30.** Thus, two second fasteners **36 (****FIG. 3****),** such as two bolts, may be inserted through the two openings **46** in the second securing portion **44** of the pivotable panel **30.**

As best seen in **FIG. 5****,** the second panel **22** may have an inwardly facing side **48** which faces the internal space **14** (and in such case the second panel **22** may also have an opposite outwardly facing side). As can be seen in **FIG. 5****,** the second panel **22** may have a fastener-receiving flange **50** projecting at an angle, for example perpendicularly, to the inwardly (and outwardly) facing side **48** of the second panel **22.** In this example, two second fasteners **36** may be inserted through the two openings **46** of the second securing portion **44** of the pivotable panel **30 (****FIG. 6****)** and then into respective openings **52** of the fastener-receiving flange **50** of the second panel **22** (only one of the openings **52** being visible in **FIG. 5****).** Although two second fasteners **36** are considered in this particular example, in other examples, the second securing portion **44** of the pivotable panel **30** may be provided with only one opening, or with three or more openings, and the number of openings **52** of the fastener-receiving flange **50** would then be configured accordingly.

As shown in **FIGS. 3** and **5****,** the first panel **20** may have an outwardly facing side **54** (and an opposite inwardly facing side **56** is visible in **FIG. 4****).** The at least one first fastener **34** shown in **FIG. 3** may thus be configured to extend from the outwardly facing side **54,** through the first panel **20** to the inwardly facing side **56** and into the first securing portion **38** of the pivotable panel **30.**

In order to enable pivoting of the pivotable panel **30** after it has been unlocked by the locking mechanism **34, 36** (in this example, after the first and second fasteners **34, 36** have been removed), there may suitably be provided a pivoting mechanism **60, 62, 64, 66.** The pivoting mechanism **60, 62, 64, 66** may suitably enable pivoting of the pivotable panel **30** between the closed position and the open position. The pivoting mechanism **60, 62, 64, 66** may comprise a first pivot **60** (best seen in **FIG. 2****)** and a second pivot **62** (best seen in **FIG. 3****).** As best seen in **FIG. 6****,** the pivotable panel **30** may comprise a first pivoting flange **64** and a second pivoting flange **66,** both forming part of the pivoting mechanism **60, 62, 64, 66.** The first pivoting flange **64** is provided with an open slot **68** configured to receive the first pivot **60.** Thus, the open slot **68** may have an open end **70** at which the first pivot **60** can be received and guided along the open slot **68.** The second pivoting flange **66** is provided with a through hole **72** configured to receive and enclose the second pivot **62.** By having the first pivoting flange **64** provided with an open slot **68** the assembling is facilitated. The second pivoting flange **66** may be mounted initially to the second pivot **62,** and then the pivotable panel **30** may be oriented and moved so that the first pivot **60** can be caught in the open slot **68** of the first pivoting flange **64.**

As can be understood from **FIGS. 2** and **3****,** the first pivot **60** may suitably be connected to or form part of the first panel **20,** and the second pivot **62** may be connected to or form part of the second panel **22.** The first and second pivots **60, 62** may be configured as pins, studs or any other suitably shape and configuration which allows for the desired pivoting between the closed position and the open position of the pivotable panel **30.**

The bottom floor **21** of the electrical component box **10** may suitably be substantially planar and may extend in a geometrical plane (the electrical component box **10** will normally be installed in a heavy-duty vehicle so that this geometrical plane extends substantially in parallel with the ground on which the heavy-duty vehicle stands). As can be understood from for example **FIGS. 2** and **6****,** in the closed position of the pivotable panel **30,** the open end **70** of the slot **68** of the first pivoting flange **64** may be facing such a geometrical plane of the bottom floor **21.** As explained before, this is advantageous, as the pivotable panel **30** can be held in its closed position in a relatively stable manner, even if the first and second fasteners **34, 36** have been removed, which may be helpful in manufacturing or servicing of the electrical component box **10.** As has been explained previously in this disclosure, when locked in its closed position, the pivotable panel **30** can contribute in absorbing loads exerted on the first panel **20** and/or the second panel **22.** To provide further structural rigidity, the pivotable panel **30** may suitably be provided with any suitable reinforcement feature. For instance, as can be seen in for example **FIG. 6** and the enlarged detail of **FIG. 5****,** the pivotable panel **30** may be provided with an elongated reinforcement beam **74.** In this example, the elongated reinforcement beam **74** has a U-shaped cross-section. The direction of extension of the elongated reinforcement beam **74** may suitably be parallel with a direction from the first panel **20** to the second panel **22.** For example, it may extend substantially perpendicularly to the inwardly facing surfaces **48, 56** of the first panel **20** and the second panel **22.**

As best seen in the enlarged detail of **FIG. 5****,** the pivotable panel **30** may have an inboard side **76.** The pivotable panel **30** may also have an opposite outboard side **78,** which is best seen in **FIG. 6****. In** the closed position of the pivotable panel **30 (****FIGS. 2** and **3****)** the inboard side **76** may be concealed. In the open position of the pivotable panel **30 (****FIGS. 4** and **6****)** the inboard side **76** is exposed. As can be seen in the enlarged detail of **FIG. 5****,** the pivotable panel **30** may suitably be provided with a window **80,** such as in the form of a large aperture through the pivotable panel **30,** through which the supported electrical components **32** may project. More specifically, at least some of the plurality of electrical components **32** that are supported by the pivotable panel **30** may be supported on the outboard side **78** and project through the window **80** to the inboard side **76.** Hereby, sensitive parts of the supported electrical components **32** may be located at the inboard side **76** even if those supported electrical components **32** are attached to the outboard side **78** of the pivotable panel **30.**

The second panel **22** may suitably comprise an abutment surface **82 (****FIG. 3****)** against which the pivotable panel **30** may land when the pivotable panel **30** is pivoted from the closed position to the open position. Thus, in the open position the pivotable panel **30** may be in contact with said abutment surface **82.** In other examples, the first panel **20** may instead or additionally be provided with such an abutment surface against which the pivotable panel **30** may land upon its pivoting opening motion.

Although the pivotable panel **30** has been discussed in relation to the first panel **20** and the second panel **22,** and the internal space **14** in between, it should be understood that the electrical component box **10** may also be provided with additional volumes for couplings, hoses, wires, other components, etc. For instance, in the illustrated example, the electrical component box **10** further comprises a third panel **84.** The third panel **84** in this case extends substantially perpendicularly upwards in relation to the bottom floor **21** and substantially in parallel with the first panel **20** and the second panel **22.** In this example, the second panel **22** is located between the first panel **20** and the third panel **84.**

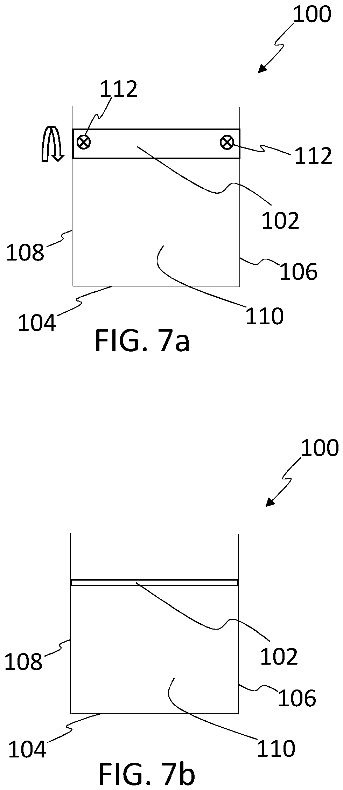

Turning now to **FIGS. 7a** and **7b****,** which very schematically illustrate an example of an electrical component box **100,** in accordance with the teachings of this disclosure. **FIG. 7a** shows the pivotable panel **102** in a closed position, whereas **FIG. 7b** shows the pivotable panel **102** in an open position.

Starting with, **FIG. 7a****,** there is illustrated an electrical component box **100** for a heavy-duty vehicle, comprising:
- a bottom floor **104,**
- a first panel **106** extending substantially perpendicularly upwards in relation to the bottom floor **104,**
- a second panel **108** extending substantially perpendicularly upwards in relation to the bottom floor **104** and extending substantially in parallel with the first panel **106,**
   wherein the bottom floor **104,** the first panel **106** and the second panel **108** together, at least partly, define an internal space **110** configured to house electrical components,
- a pivotable panel **102** configured to support a plurality of electrical components, such as fuses, the pivotable panel **102** having:
   i) a closed position, in which access to the supported electrical components and at least some other electrical components housed in said internal space **110** is counteracted, and
   ii) an open position, in which access to the supported electrical components and said at least some other electrical components housed in said internal space **110** is enabled,
- a locking mechanism **112** configured to lock the pivotable panel **102** in said closed position by securing the pivotable panel **102** to the first panel **106** and the second panel **108,** thereby causing the pivotable panel **102** to contribute in absorbing load exerted on at least one of the first panel **106** and the second panel **108,** and preventing the pivotable panel **102** from pivoting,
wherein unlocking of the pivotable panel **102,** by the locking mechanism **112,** allows the pivotable panel **102** to be pivoted from the closed position to the open position.

An arrow adjacent to the second panel **108** in **FIG. 7a** is included to indicate the possibility of pivoting the pivotable panel **102** from the illustrated closed position to the open position in **FIG. 7b****.**

Example 1: An electrical component box for a heavy-duty vehicle, comprising:
- a bottom floor,
- a first panel extending substantially perpendicularly upwards in relation to the bottom floor,
- a second panel extending substantially perpendicularly upwards in relation to the bottom floor and extending substantially in parallel with the first panel,
   wherein the bottom floor, the first panel and the second panel together, at least partly, define an internal space configured to house electrical components,
- a pivotable panel configured to support a plurality of electrical components, such as fuses, the pivotable panel having:
   i) a closed position, in which access to the supported electrical components and at least some other electrical components housed in said internal space is counteracted, and
   ii) an open position, in which access to the supported electrical components and said at least some other electrical components housed in said internal space is enabled,
- a locking mechanism configured to lock the pivotable panel in said closed position by securing the pivotable panel to the first panel and the second panel, thereby causing the pivotable panel to contribute in absorbing load exerted on at least one of the first and second panel, and preventing the pivotable panel from pivoting,
wherein unlocking of the pivotable panel, by the locking mechanism, allows the pivotable panel to be pivoted from the closed position to the open position.

Example 2: The electrical component box of example 1, further comprising:
- a pivoting mechanism for enabling pivoting of the pivotable panel between the closed position and open position, wherein the pivoting mechanism comprises a first pivot and a second pivot, wherein the pivotable panel comprises a first pivoting flange forming part of the pivoting mechanism and being provided with an open slot configured to receive said first pivot, and a second pivoting flange provided with a through hole configured to receive and enclose said second pivot.

Example 3: The electrical component box of example 2, wherein the first pivot is connected to or forms part of the first panel, and the second pivot is connected to or forms part of the second panel.

Example 4: The electrical component box of any of examples 2-3, wherein the bottom floor is substantially planar and extends in a geometrical plane, wherein in the closed position of the pivotable panel an open end of the open slot is facing said geometrical plane.

Example 5: The electrical component box of any of examples 1-4, wherein the locking mechanism comprises at least one first fastener and at least one second fastener, wherein the pivotable panel has a first securing portion at one end of the pivotable panel, the first securing portion being configured to receive said at least one first fastener in a first direction, wherein the pivotable panel has a second securing portion at an opposite end of the pivotable panel, the second securing portion being configured to receive said at least one second fastener in a second direction which is perpendicular to said first direction.

Example 6: The electrical component box of example 5, wherein the pivotable panel has a supporting surface for supporting at least some of said plurality of electrical components, the supporting surface extending from said one end to said opposite end of the pivotable panel, wherein the first securing portion is formed by a securing flange which is projecting substantially perpendicularly to the supporting surface of the pivotable panel and substantially in parallel with the first panel, wherein the securing flange is provided with at least one opening for receiving said at least one first fastener.

Example 7: The electrical component box of example 6, wherein the second securing portion is formed by an area of the pivotable panel which is parallel with said supporting surface, wherein the second securing portion is provided with at least one opening for receiving said at least one second fastener.

Example 8: The electrical component box of any of examples 5-7, wherein the first panel has an inwardly facing side which faces said internal space and an opposite outwardly facing side, wherein said at least one first fastener is configured to extend from the outwardly facing side through the first panel to the inwardly facing side and into the first securing portion of the pivotable panel.

Example 9: The electrical component box of any of examples 5-8, wherein the second panel has an inwardly facing side which faces said internal space and an opposite outwardly facing side, wherein the second panel has a fastener-receiving flange projecting at an angle, such as perpendicularly, to said inwardly and outwardly facing sides of the second panel, wherein said at least one second fastener is configured to extend from the second securing portion of the pivotable panel and into the fastener-receiving flange of the second panel.

Example 10: The electrical component box of any of examples 1-9, wherein the pivotable panel is provided with an elongated reinforcement beam, such as a beam having a U-shaped cross-section, wherein the direction of extension of the elongated reinforcement beam is parallel with a direction from the first panel to the second panel.

Example 11: The electrical component box of any of examples 1-10, wherein the pivotable panel has an inboard side and an opposite outboard side, wherein in the closed position of the pivotable panel the inboard side is concealed and in the open position of the pivotable panel the inboard side is exposed, wherein the pivotable panel is provided with a window, wherein said plurality of electrical components supported by the pivotable panel are supported on the outboard side and project through the window to the inboard side.

Example 12: The electrical component box of any of examples 1-11, wherein the second panel comprises an abutment surface against which the pivotable panel lands upon its pivoting motion from the closed position to the open position, wherein in said open position the pivotable panel is in contact with said abutment surface.

Example 13: The electrical component box of any of examples 1-12, wherein the electrical component box is a battery box, wherein said internal space is configured to receive one or more batteries between the bottom floor and the pivotable panel.

Example 14: The electrical component box of example 13, further comprising:
- a tray defining said bottom floor of the battery box, wherein said first and second panels are fixated to said tray, wherein said one or more batteries are configured to be received on said tray or on a drawer received by the tray.

Example 15: The electrical component box of any of examples 1-14, further comprising:
- a third panel extending substantially perpendicularly upwards in relation to the bottom floor, and extending substantially in parallel with the first panel and the second panel, wherein the second panel is located between the first panel and the third panel.

Example 16: The electrical component box of example 5 or any example referring to example 5, wherein the locking mechanism comprises at least two first fasteners.

Example 17: The electrical component box of example 5 or any example referring to example 5, wherein the locking mechanism comprises at least two fasteners.

Example 18: The electrical component box of any of examples 1-17, wherein the pivotable panel is located closer to a respective upper end of the first panel and the second panel, and located farther from a respective lower end of the first panel and the second panel.

Example 19: A heavy-duty vehicle comprising an electrical component box according to any one of examples 1-18.

Example 20: The heavy-duty vehicle of example 19, wherein the electrical component box is installed on a lateral side of a heavy-duty vehicle and is accessible from outside of the heavy-duty vehicle.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. An electrical component box for a heavy-duty vehicle, comprising:
- a bottom floor,
- a first panel extending substantially perpendicularly upwards in relation to the bottom floor,
- a second panel extending substantially perpendicularly upwards in relation to the bottom floor and extending substantially in parallel with the first panel,
wherein the bottom floor, the first panel and the second panel together, at least partly, define an internal space configured to house electrical components,
- a pivotable panel configured to support a plurality of electrical components, such as fuses, the pivotable panel having:
i) a closed position, in which access to the supported electrical components and at least some other electrical components housed in said internal space is counteracted, and
ii) an open position, in which access to the supported electrical components and said at least some other electrical components housed in said internal space is enabled,
- a locking mechanism configured to lock the pivotable panel in said closed position by securing the pivotable panel to the first panel and the second panel, thereby causing the pivotable panel to contribute in absorbing load exerted on at least one of the first and second panel, and preventing the pivotable panel from pivoting,
wherein unlocking of the pivotable panel, by the locking mechanism, allows the pivotable panel to be pivoted from the closed position to the open position.

2. The electrical component box of claim 1, further comprising:
- a pivoting mechanism for enabling pivoting of the pivotable panel between the closed position and open position, wherein the pivoting mechanism comprises a first pivot and a second pivot, wherein the pivotable panel comprises a first pivoting flange forming part of the pivoting mechanism and being provided with an open slot configured to receive said first pivot, and a second pivoting flange provided with a through hole configured to receive and enclose said second pivot.

3. The electrical component box of claim 2, wherein the first pivot is connected to or forms part of the first panel, and the second pivot is connected to or forms part of the second panel.

4. The electrical component box of any of claims 2-3, wherein the bottom floor is substantially planar and extends in a geometrical plane, wherein in the closed position of the pivotable panel an open end of the open slot is facing said geometrical plane.

5. The electrical component box of any of claims 1-4, wherein the locking mechanism comprises at least one first fastener and at least one second fastener, wherein the pivotable panel has a first securing portion at one end of the pivotable panel, the first securing portion being configured to receive said at least one first fastener in a first direction, wherein the pivotable panel has a second securing portion at an opposite end of the pivotable panel, the second securing portion being configured to receive said at least one second fastener in a second direction which is perpendicular to said first direction.

6. The electrical component box of claim 5, wherein the pivotable panel has a supporting surface for supporting at least some of said plurality of electrical components, the supporting surface extending from said one end to said opposite end of the pivotable panel, wherein the first securing portion is formed by a securing flange which is projecting substantially perpendicularly to the supporting surface of the pivotable panel and substantially in parallel with the first panel, wherein the securing flange is provided with at least one opening for receiving said at least one first fastener.

7. The electrical component box of claim 6, wherein the second securing portion is formed by an area of the pivotable panel which is parallel with said supporting surface, wherein the second securing portion is provided with at least one opening for receiving said at least one second fastener.

8. The electrical component box of any of claims 5-7, wherein the first panel has an inwardly facing side which faces said internal space and an opposite outwardly facing side, wherein said at least one first fastener is configured to extend from the outwardly facing side through the first panel to the inwardly facing side and into the first securing portion of the pivotable panel.

9. The electrical component box of any of claims 5-8, wherein the second panel has an inwardly facing side which faces said internal space and an opposite outwardly facing side, wherein the second panel has a fastener-receiving flange projecting at an angle, such as perpendicularly, to said inwardly and outwardly facing sides of the second panel, wherein said at least one second fastener is configured to extend from the second securing portion of the pivotable panel and into the fastener-receiving flange of the second panel.

10. The electrical component box of any of claims 1-9, wherein the pivotable panel is provided with an elongated reinforcement beam, such as a beam having a U-shaped cross-section, wherein the direction of extension of the elongated reinforcement beam is parallel with a direction from the first panel to the second panel.

11. The electrical component box of any of claims 1-10, wherein the pivotable panel has an inboard side and an opposite outboard side, wherein in the closed position of the pivotable panel the inboard side is concealed and in the open position of the pivotable panel the inboard side is exposed, wherein the pivotable panel is provided with a window, wherein said plurality of electrical components supported by the pivotable panel are supported on the outboard side and project through the window to the inboard side.

12. The electrical component box of any of claims 1-11, wherein the second panel comprises an abutment surface against which the pivotable panel lands upon its pivoting motion from the closed position to the open position, wherein in said open position the pivotable panel is in contact with said abutment surface.

13. The electrical component box of any of claims 1-12, wherein the electrical component box is a battery box, wherein said internal space is configured to receive one or more batteries between the bottom floor and the pivotable panel.

14. A heavy-duty vehicle comprising an electrical component box according to any one of claims 1-13.

15. The heavy-duty vehicle of claim 14, wherein the electrical component box is installed on a lateral side of a heavy-duty vehicle and is accessible from outside of the heavy-duty vehicle.
